**Europäisches Patentamt**

**European Patent Office**

**Office européen des brevets**

(19)

(11) Numéro de publication : **0 494 560 A2**

## (12) DEMANDE DE BREVET EUROPEEN

(21) Numéro de dépôt : **91403454.1**

(22) Date de dépôt : **19.12.91**

(51) Int. Cl.$^5$ : **H05K 7/20,** H05K 3/34, H01L 23/498

(30) Priorité : **27.12.90 FR 9016290**

(43) Date de publication de la demande : **15.07.92 Bulletin 92/29**

(84) Etats contractants désignés : **BE DE GB IT**

(71) Demandeur : **SAT (Société Anonyme de Télécommunications)**
**6, avenue d'Iéna**
**F-75116 Paris (FR)**

(72) Inventeur : **Picault, Robert, Jean Brusvily**
**F-22100 Dinan (FR)**
Inventeur : **Morillon, Pierre, Charles**
**20-21, Résidence du Parc**
**F-22100 Dinan (FR)**
Inventeur : **Le Meur, Yves, Marie, Eugène**
**"Le Fod", Brélévenez**
**F-22300 Lannion (FR)**
Inventeur : **Roche, Bernard Rougoulouarn**
**F-22560 Trebeurden (FR)**
Inventeur : **Le Guern, Yvon**
**22 Venelle de Crec'h Ewano**
**F-22560 Trebeurden (FR)**

(74) Mandataire : **Bloch, Gérard et al**
**2, square de l'Avenue du Bois**
**F-75116 Paris (FR)**

(54) **Support de circuit imprimé électrique à moyens de drainage thermique.**

(57)   Il s'agit d'un support (1) d'au moins un circuit imprimé d'interconnexion électrique destiné à recevoir des composants (5). Il comporte une face (2) libre de circuit, contre celle-ci et en surface, une plaque de cuivre (3) conductrice de la chaleur pour drainer l'énergie thermique des composants (5). La plaque (3) est ajourée pour le passage des contacts (7) des composants (5) fixés à la plaque (3) et leur liaison souple à des métallisations sur le support (1).

FIG.1

EP 0 494 560 A2

La présente invention concerne les circuits imprimés. Un circuit imprimé comporte par exemple un support, ou carte, constitué d'un flanc de tissu de verre enrobé de résine époxy, sur au moins l'une des faces duquel a été imprimé un réseau de conducteurs d'interconnexion de composants. On utilise souvent plusieurs de ces circuits imprimés associés, en une matrice multicouche, les uns aux autres par des faces qui ne peuvent plus recevoir de composants mais qui augmentent notablement la capacité d'interconnexion. Une telle matrice est percée de trous métallisés traversants ou non. Dans ce dernier cas, il s'agit d'accéder électriquement à l'une des faces d'un circuit intérieur de la matrice et on parle de "vias".

Les composants peuvent être des composants hybrides ou boîtiers à relativement forte dissipation thermique, montés sur un circuit imprimé de plusieurs manières. Il peut s'agir de composants montés en surface (CMS), par exemple dans des supports de puce (chip carrier) constitués généralement de boîtiers en céramique fixés sur le circuit, par exemple collés, les bornes, ou pattes, des composants étant reliées à des métallisations extérieures de leurs boîtiers, elles mêmes étant reliées à des pistes conductrices du circuit. Il peut aussi s'agir de composants enfichés par leurs pattes dans des trous ménagés dans le circuit imprimé ou la matrice de circuits imprimés, le long de deux lignes (on parle ainsi de "dual in line package " DIL) ou selon un réseau en grille (on parle alors de "pin grid array" PGA).

Pour le cas des composants boîtiers CMS, il faut avoir adapté, dans les sens de la longueur et de la largeur, les coefficients de dilatation thermique des supports des composants en céramique et de la couche de réception, en époxy, du support de circuit imprimé ou de la matrice de circuits imprimés, surtout s'il s'agit de grands formats. A cet effet, on noie, ou incorpore, par stratification dans la matrice et près de ses faces externes, des flancs par exemple de Cuivre-Invar-Cuivre. Pour fixer les idées, le coefficient de dilatation de l'époxy est de $17.10^{-6}$/degré, celui de la céramique, de $7.10^{-6}$/degré, celui du Cu-Inv-Cu, compris sensiblement entre $5.10^{-6}$/degré et $8.10^{-6}$/degré selon les épaisseurs relatives de cuivre et d'invar.

Outre leur fonction d'adaptation des coefficients de dilatation, les strates de Cu-Inv-Cu assurent aussi une fonction de drainage des calories dissipées par les composants vers des radiateurs latéraux. Cependant, les couches d'époxy, entre les strates de Cu-Inv-Cu et les composants, constituent des écrans thermiques, limitant les performances de l'ensemble.

Pour le cas des composants enfichés, il faut avoir percé des trous à travers les strates de Cu-Inv-Cu. A cause du cuivre, et pour éviter les courts-circuits, ces trous doivent présenter un diamètre relativement important. Mais alors on a enlevé relativement beaucoup de matériau d'adaptation des coefficients de dilatation et de drainage des calories, surtout pour les composants PGA. De plus, ce matériau d'adaptation et de drainage est coûteux et son perçage délicat. Enfin, après avoir percé ces trous, il faut les boucher d'époxy avant d'avoir ensuite à repercer les bouchons d'époxy afin de les métalliser.

La présente invention vise à éliminer tous ces inconvénients.

On connait, par le document FR-A-2 634 616, un support de circuit imprimé agencé pour recevoir un composant boîtier CMS par l'intermédiaire d'une cale à coefficient de dilatation adapté à celui du boîtier, le composant étant électriquement relié au circuit imprimé par des liaisons souples et l'énergie thermique dissipée par le composant étant évacuée par des couches noyées dans le support et par l'intermédiaire de la cale et de puits thermiques traversant le support.

Mais un tel agencement présente toujours les inconvénients d'avoir à ménager non seulement des couches de drainage thermique mais encore des puits thermiques, à disposer de moyens d'adaptation de coefficients de dilatation et à limiter l'implantation des composants CMS sur le support en des endroits non imprimés de pistes conductrices d'interconnexion.

On connaît, par le document EP-A-0 085 622, un support de circuit imprimé d'interconnexion électrique destiné à recevoir des composants électriques, comprenant une face libre de circuit et, contre cette face libre, des moyens externes, en surface, conducteurs de chaleur pour drainer l'énergie thermique des composants.

Mais ce support est en fait une combinaison d'un dissipateur thermique et de drains en forme de bossage, entre les composants et le dissipateur de réalisation industrielle délicate. En outre, avec un tel support, les problèmes de contrainte différentielle entre les composants et le support ne peuvent être résolus qu'au niveau de la connectique des composants. Dans le support de ce dernier art antérieur, la souplesse mécanique ne peut être assurée que par des joints de colle qui n'évitent pas les contraintes exercées sur les interconnexions par celles, différentielles, entre le support et son boîtier. Ce support est donc limité à des composants du type dit "chip carriers" de petites dimensions pour éviter la rupture des connexions électriques.

Et c'est ainsi que la demanderesse propose son invention qui concerne d'abord un support d'au moins un circuit imprimé d'interconnexion électrique destiné à recevoir des composants électriques fixés à une plaque externe qui est disposée contre une face du support libre de circuit et qui est conductrice de chaleur pour drainer l'énergie thermique des composants, caractérisé par le fait que ladite plaque est ajourée pour le passage des contacts des composants et leur liaison à des métallisations sur le support.

L'invention concerne aussi un support d'au moins un circuit imprimé d'interconnexion électrique percé d'ouvertures pour recevoir des composants électriques fixés à une plaque externe continue qui est disposée contre une face du support libre de circuit et qui est conductrice de chaleur pour drainer l'énergie thermique des composants, caractérisé par le fait que les composants électriques sont reçus dans les ouvertures du support.

Cette deuxième solution au problème de l'invention est préférée car le matériau enlevé pour ménager les ouvertures est celui du support et non celui de la plaque de drainage dont la fonction de drainage n'est donc pas altérée. Le support peut ainsi être ouvert des quatre côtés d'un composant si des pattes de connexion du composant font saillie hors de ses quatre côtés.

De préférence, les coefficients de dilatation de la plaque de drainage thermique externe et de la portion adjacente du support sont sensiblement adaptés.

Avantageusement, la plaque de drainage thermique est en cuivre.

Les pattes de connexion des composants peuvent avantageusement être reliées au circuit imprimé par des liaisons souples, ou boucles d'aisance, pour tenir compte des dilatations différentielles.

L'invention sera mieux comprise à l'aide de la description suivante de deux formes de réalisation d'un circuit multicouche de l'invention, en référence au dessin annexé sur lequel

– la figure 1 représente la première forme de réalisation, avec une plaque de drainage thermique ajourée;

– la figure 2 représente la deuxième forme de réalisation, avec une plaque de drainage thermique continue;

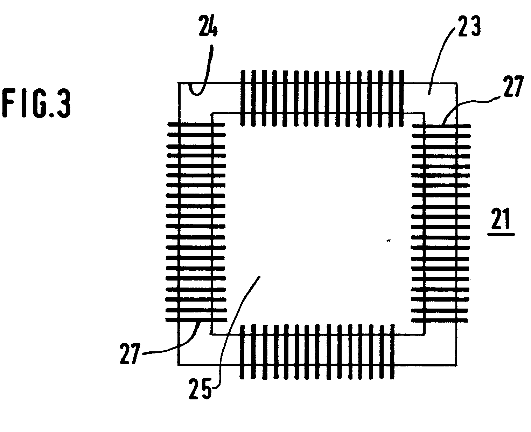

– la figure 3 représente une vue de dessus d'un composant, à pattes de connexion disposées sur ses quatre côtés, fixé sur le circuit multicouche de la figure 2.

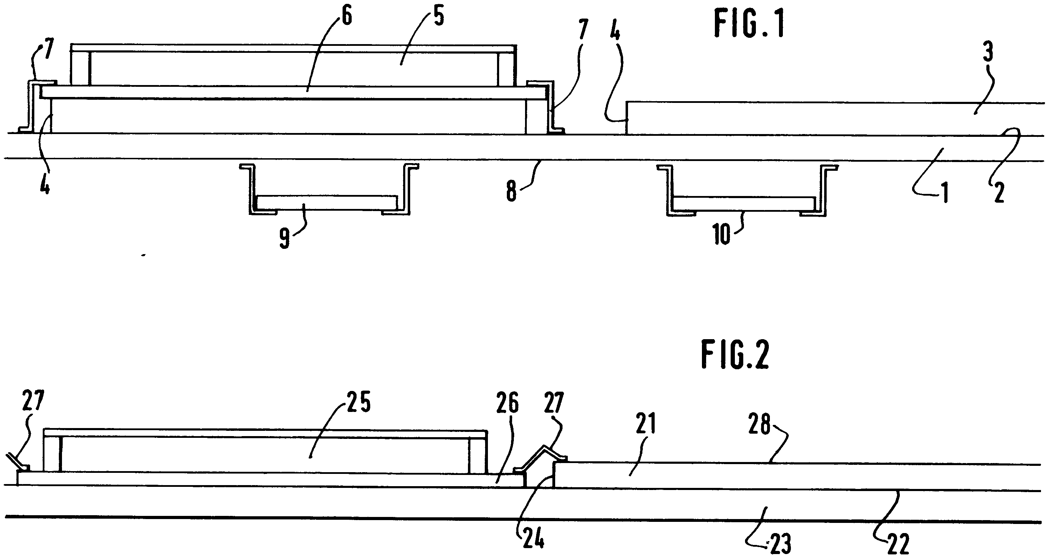

La figure 1 représente un support multicouche 1 de plusieurs circuits imprimés d'interconnexion, dont une face 2, d'une couche externe ici d'époxy, est libre de tout circuit d'interconnexion. Contre cette face libre 2 s'étend une plaque externe 3, conductrice de chaleur, ici en cuivre, pour drainer l'énergie thermique de composants électriques que le circuit multicouche est destiné à recevoir.

Les coefficients de dilatation de l'époxy et du cuivre sont du même ordre de grandeur et le plaquage cuivre- époxy est une technique qui est maintenant parfaitement maitrisée, sans risque de délamination ultérieure.

Mais on notera qu'au lieu du cuivre, on pourrait aussi considérer d'autres matériaux conducteurs, comme l'aluminium ou des alliages d'aluminium ou de cuivre.

La plaque de drainage 3 est ajourée et percée de lumières 4 pour le passage de contacts de connexion de composants, comme le composant 5. Il s'agit d'un composant-boîtier fixé sur la plaque 3 par l'intermédiaire d'une embase 6 ici collée thermiquement sur la plaque 3. Le composant 5 est relié électriquement à un circuit d'interconnexion du circuit multicouche 1 par l'intermédiaire de liaisons souples de connexion, ou boucles d'aisance, 7, pour tenir compte des dilatations différentielles entre le cuivre et l'époxy, à coefficient de dilatation élevé, d'une part, et le matériau du boîtier - ici de la céramique - à coefficient de dilatation faible, d'autre part, les boucles passant donc à travers deux lumières 4 ménagées de deux côtés opposés du composant 5 et fixées à des métallisations sur le support 1, métallisations de surface ou trous métallisés, non représentés, ménagés depuis la face 2 et reliés au circuit d'interconnexion considéré.

On notera que la largeur des lumières 4 est la plus faible possible pour réduire au mieux la discontinuité de la plaque de drainage thermique 3 dans la direction sécante de ces lumières, l'écoulement thermique n'étant par contre pas du tout perturbé dans la direction perpendiculaire.

Sur la face 8 du support multicouche 1, opposée à la face 2 et comportant un circuit imprimé d'interconnexion, sont montés des composants CMS, dont deux, 9, 10, sont représentés.

La figure 2 représente aussi un support multicouche 21, dont une face 22 est libre de tout circuit d'interconnexion et contre laquelle s'étend une plaque externe 23 de drainage thermique. La plaque 23 est une plaque continue non ajourée et c'est le support 21 qui est ajouré et percé d'ouvertures 24 de réception de composants électriques, ici le composant 25. Ces composants sont fixés sur la plaque 23, par collage. La face 28 du support 21, opposée à la face 22, comporte un circuit d'interconnexion auquel le composant 25 est relié électriquement par des contacts de connexion 27, en forme de liaisons souples, pour tenir compte de la dilatation différentielle entre le support multicouche 21 et le matériau 26 récepteur du composant 25. Les pattes de connexion du composant 25 font ici saillie hors de tous ses côtés.

Dans cette deuxième variante de réalisation du support de l'invention, la plaque de drainage thermique 23 n'est pas percée et sa fonction de drainage n'est donc nullement altérée.

## Revendications

1. Support (1) d'au moins un circuit imprimé d'interconnexion électrique destiné à recevoir des composants électriques (5) fixés à une plaque externe (3) qui est disposée contre une face (2) du support (1) libre de circuit et qui est conductrice de chaleur pour drainer l'énergie thermique des composants (5), caractérisé par le fait que ladite plaque (3) est ajourée pour le passage des contacts (7) des composants (5) et leur liaison à des métallisations sur le support (1).

2.  Support (21) d'au moins un circuit imprimé d'interconnexion électrique percé d'ouvertures (24) pour recevoir des composants électriques (25) fixés à une plaque externe continue (23) qui est disposée contre une face (22) du support (21) libre de circuit et qui est conductrice de chaleur pour drainer l'énergie thermique des composants (25), caractérisé par le fait que les composants électriques (25) sont reçus dans les ouvertures (24) du support. (21).

3.  Support selon l'une des revendications 1 et 2, dans lequel les pattes de connexion des composants (5; 25) sont reliées au circuit imprimé du support par des liaisons souples (7; 27).

4.  Support selon l'une des revendications 1 à 3, dans lequel les coefficients de dilatation de la plaque de drainage thermique externe (3; 23) et de la portion adjacente du support (1; 21) sont sensiblement adaptés.

5.  Support selon la revendication 4, dans lequel la plaque de drainage thermique (3; 23) est en cuivre.
    6. Support selon l'une des revendications 1 à 5, qui est un support multicouche (1; 21) de plusieurs circuits imprimés d'interconnexion.

EP 0 494 560 A2

**FIG.1**

**FIG.2**

FIG.3

EP 0 494 560 A2